Europäisches Patentamt

European Patent Office    (11) Numéro de publication:    **0 073 167**

Office européen des brevets    **A1**

(12)    **DEMANDE DE BREVET EUROPEEN**

(21) Numéro de dépôt: **82401543.2**    (51) Int. Cl.³: **G 11 C 11/40**
    **H 03 K 3/353**

(22) Date de dépôt: **17.08.82**

(30) Priorité: **21.08.81 FR  8116114**

(43) Date de publication de la demande:
    **02.03.83  Bulletin  83/9**

(84) Etats contractants désignés:
    **DE GB IT NL SE**

(71) Demandeur: **THOMSON-CSF**
    **173, Boulevard Haussmann**
    **F-75379 Paris Cedex 08(FR)**

(72) Inventeur: **Pham, Ngu Tung**
    **THOMSON-CSF SCPI 173, bld Haussmann**
    **F-75379 Paris Cedex 08(FR)**

(74) Mandataire: **Lepercque, Jean  et  al,**
    **THOMSON-CSF SCPI 173, Bld Haussmann**
    **F-75379 Paris Cedex 08(FR)**

(54) Circuit logique bistable utilisant des transistors à effet de champ à faible tension de seuil, et dispositif de mémorisation comportant un tel circuit.

㉗ Ce circuit logique comprend deux transistors à effet de champ ($T_1$, $T_2$) en série dont les grilles sont reliées à la tension d'alimentation par une première charge $Z_1$. La source du premier transistor à effet de champ ($T_1$) est reliée à la masse. Le drain du deuxième transistor à effet de champ est relié d'une part à la tension d'alimentation par une deuxième charge $Z_2$ et à la grille d'un troisième transistor à effet de champ ($T_3$) dont le drain est relié à la tension d'alimentation et la source au point commun constitué par le drain du premier transistor à effet de champ $T_1$ et par la source du deuxième transistor à effet de champ $T_2$ par l'intermédiaire d'une diode Schottky ($d_{c2}$).

Application à un circuit de mémorisation à accès aléatoire.

**FIG.4**

EP 0 073 167 A1

Croydon Printing Company Ltd

# CIRCUIT LOGIQUE BISTABLE UTILISANT DES TRANSISTORS A EFFET DE CHAMP A FAIBLE TENSION DE SEUIL ET DISPOSITIF DE MEMORISATION COMPORTANT UN TEL CIRCUIT

L'invention concerne un circuit logique bistable utilisant des transistors à effet de champ à faible tension de seuil et un dispositif de mémorisation comportant un tel circuit.

Les mémoires statiques à accès aléatoire sont composées de matrices d'éléments actifs à deux états stables, l'un correspondant à l'état "0", l'autre à l'état "1". L'adressage de chaque élément qui est donc un circuit bistable pour la lecture ou l'écriture se fait par sélection de la ligne et de la colonne à l'intersection desquelles se trouve l'élément adressé.

La qualité et l'intérêt de chaque type de mémoire dépend essentiellement de la stabilité et de la dimension réduite de chaque élément. Il est connu de réaliser ces mémoires en technologie "MESFET" sur Arséniure de Gallium (AsGa).

Mais la grande densité des mémoires exige une technologie de circuits logiques de très faible consommation, ce qui élimine une logique à éléments de mémoire tampon de type "BFL" (de l'anglo-saxon "Buffered FET Logic") à transistors "MESFET normalement conducteur" qui est la seule dont la technologie soit très éprouvée. Il reste des logiques comportant des transistors à effet de champ et des diodes Schottky de type "SDFL" (de l'anglo-saxon "Schottky diode - FET logic"), et des logiques performantes à base de transistors à effet de champ à jonction de type "E.J.FET.L" (de l'anglo-saxon "Enhanced Junction FET Logic") qui répondent bien au critères de consommation mais dont les technologies sont encore trop complexes pour être appliquées pour l'obtention de circuits à grande intégration (LSI).

La demande de brevet européen publiée sous le N° 0 021 858 décrit une nouvelle logique à base de transistors "MESFET" à très faible tension de seuil négative qui répond bien aux nombreux critères des circuits de grande intégration (LSI) : faible consommation, technologie simple et permettant une bonne tolérance au niveau de la fabrication.

L'invention se propose de réaliser des circuits bistables utilisant cette technologie. Elle concerne donc des éléments de mémoire pouvant avoir une très faible surface, être facilement intégrés et par conséquent l'obtention de mémoires à grande densité d'intégration. Ainsi elle permet de réaliser sur un substrat en Arséniure de Gallium (AsGa) des mémoires statiques à accès aléatoire de grande densité (plus de 256 bits) et de très grande vitesse d'accès (moins d'une nanoseconde).

L'invention a pour objet un circuit logique bistable utilisant des transistors à effet de champ à faible tension de seuil, connectés entre les deux bornes d'un générateur de tension d'alimentation, caractérisé en ce qu'il comporte deux transistors à effet de champ en série dont les grilles sont reliées entre elles et à la première borne du générateur de tension d'alimentation par une première charge, la source du premier transistor à effet de champ étant reliée à la deuxième borne du générateur de tension d'alimentation, le drain du deuxième transistor à effet de champ étant relié d'une part à la première borne du générateur de tension d'alimentation par une deuxième charge et d'autre part à la grille d'un troisième transistor à effet de champ dont le drain est relié à la première borne du générateur de tension d'alimentation et la source au point commun constitué par le drain du premier transistor et par la source du deuxième transistor par l'intermédiaire d'une diode Schottky ; ce point commun constituant la borne de sortie dudit circuit bistable.

L'invention a également pour objet un dispositif de mémorisation comportant un tel circuit bistable.

L'invention sera mieux comprise, et d'autres caractéristiques apparaîtront, au moyen de la description qui suit et des dessins qui l'accompagnent parmi lesquels :

- les figures 1 à 3 représentent des circuits bistables de l'art connu ;

- la figure 4 représente le circuit bistable de l'invention ;

- la figure 5 représente le schéma d'une mémoire comportant des circuits bistables selon l'invention ;

- les figures 6 à 9 représentent des détails de la mémoire illustrée à la figure 5 ;

- la figure 10 représente un schéma plus détaillé de cette mémoire comportant des circuits bistables selon l'invention.

Les circuits que l'on va considérer peuvent être branchés entre les deux bornes d'un générateur de tension d'alimentation, pour simplifier on les considérera pris entre la masse et la tension + V.

L'invention utilise la technologie des circuits logiques à "MESFET" à tension de seuil faiblement négative, aussi appelés "MESFET" de type "quasi-normalement bloqués".

L'élément principal de l'invention est une bascule bistable utilisable comme cellule élémentaire des mémoires statiques à accès aléatoire.

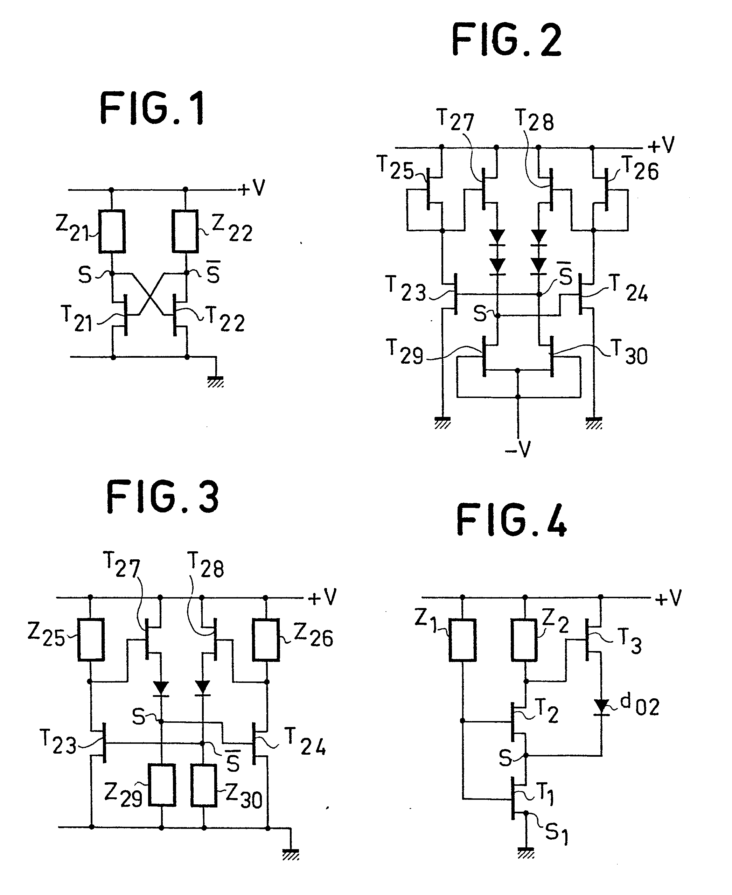

En général, on obtient une bascule bistable en croisant deux inverseurs logiques comme le montre la figure 1, en considérant une logique à couplage direct dite "DCFL" ("Direct Coupled FET Logic").

A la figure 2 on considère la logique bufférisée dite "BFL" ("Buffered FET Logic") à "MESFET" "normalement conducteurs". Les transistors $T_5$ et $T_6$, $T_9$ et $T_{10}$ dont la grille est reliée à la source jouent le rôle de résistances saturables. Dans ce cas on doit utiliser deux sources de tensions de signes opposés.

Et enfin à la figure 3 on considère la logique à faible seuil dite "LTFL" ("Low Threshold FET Logic") qui permet de n'utiliser plus qu'une source de tension. Si on considère des transistors à effet de champ à grille Schottky ("MESFET"), ces transistors sont du type "quasi normalement bloqués". On ne considérera d'ailleurs, dans la suite que des transistors à effet de champ de ce type.

On a à la figure 4 le circuit bistable de l'invention. Cette bascule bistable a de nombreux avantages sur les inverseurs croisés illustrés aux figures précédentes : sa simplicité, le moins grand nombre de ses éléments, et le fait qu'il n'y a pas de croisements. Ces caractéristiques contribuent à économiser de la place pour les circuits à grande densité. De plus cette cellule est simple à adresser, ce qui simplifie les circuits logiques d'accès.

Le circuit bistable est constitué par deux transistors à effet de champ de type "quasi normalement bloqués" $T_1$ et $T_2$ en série dont les grilles sont reliée à +V par une même charge $Z_1$. La source de $T_1$ est reliée à la masse. Le drain de $T_2$ est relié d'une part à +V par une charge $Z_2$ et d'autre part à la grille de $T_3$. Le drain de $T_3$ est relié à +V et sa source est bouclée au point commun formé par le drain de $T_1$ et la source de $T_2$ par une diode

Schottky $d_{c2}$ : ce point commun constituant la sortie du circuit bistable. Ces charges $Z_1$ et $Z_2$ sont des charges résistives qui peuvent être notamment des résistances saturables. Dans la suite de la description lorsque l'on parlera de charge $Z_i$, on considérera des charges de ce type. On parlera, aussi, de niveau bas qui correspond à l'état "0" du bistable, et de niveau haut qui correspond à l'état "1" du bistable.

On a les tensions caractéristiques suivantes :

$V_T$ = tension de seuil des transistors à effet de champ

$V_H$ = niveau haut

$V_B$ = niveau bas

$V_{0S}$ = tension d'ouverture des diodes Schottky ($V_{0S} \simeq 0.7$ V)

$V_S$ = tension de seuil de basculement définie par :

$$i_T(V_S) = i_Z$$

avec $i_T(V_S)$ = courant du transistor à effet de champ quand $V_{GS} = V_S$

$i_Z$ = courant de la charge Z

$V_{di}$ = tension de déchet des transistors à effet de champ par rapport à la charge Z ($V_{di} \simeq 0.2$ Volt).

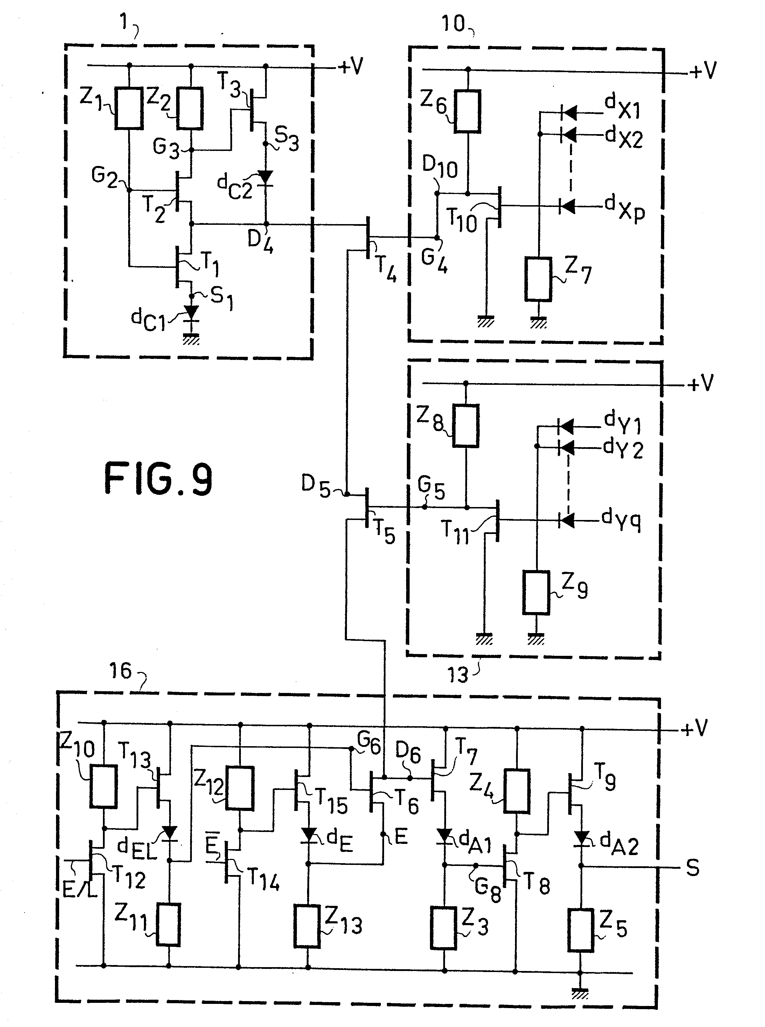

Pour la suite de la description, on introduit une diode Schottky $d_{c1}$ entre la source du transistor $T_1$ et la masse, comme cela est représenté à la figure 9. Cela ne modifie en rien le fonctionnement de ce circuit bistable, mais cela permet, lorsque l'on va considérer une mémoire utilisant ces circuits bistables comme éléments de base de bien travailler en régime bloqué-saturé avec des transistors à effet de champ de type "MESFET" "quasi-normalement bloqués".

D'après la figure 9, le tableau 1 situé en fin de description montre les deux états stables de la cellule. $V_{di}$ étant la tension de déchet dans le transistor $T_i$, $V_{0S}$ la tension Schottky et $V_{S3}$ la tension au point $S_3$ on conservera par la suite ces conventions : ainsi $V_{D4}$ est la tension au point $D_4$.

$V_{S3}$ étant la tension de seuil de basculement de $T_3$ par rapport à $i_{T_1}$.

On a les deux états :

Etat "0" : $T_1$ et $T_2$ sont passants, $T_3$ bloqué

Etat "1" : $T_1$ et $T_3$ sont passants, $T_2$ bloqué.

Cette bascule bistable utilisée en cellule mémoire fonctionne en "miroir de courant" entre les transistors à effet de champ $T_2$ et $T_3$, si $T_2$ est passant, $T_3$ est bloqué et réciproquement.

On a vu précédemment que l'état de la cellule est lié à celui du transistor $T_2$. On peut donc forcer la bascule vers l'un des deux états stables en agissant sur $V_{D_4}$ :

$$\text{Si } V_{GS_2} = V_{G_2} - V_{D_4} > V_{S_2}$$

$V_{GS_2}$ étant la tension entre la grille et la source du transistor $T_2$.

$V_{S_2}$ : tension de seuil de basculement de $T_2$ par rapport à $Z_2$, $T_2$ devient passant et la cellule bascule à l'état "0".

Par contre, si $V_{GS_2} < V_{S_2}$

$T_2$ est bloqué, la cellule bascule à l'état "1".

D'où le point de basculement du bistable :

$$V_{D_4}(S) = V_{G_2} - V_{S_2} = 2V_{0S} - V_{S_2}$$

Les niveaux de sortie caractéristiques de la bascule sont donc :

$$V_{D_4}(H) = V - V_{S_3} - V_{0S} \quad \text{(Niveau Haut)}$$

$$V_{D_4}(B) = V_{0S} + V_{d_1} \quad \text{(Niveau Bas)}$$

$$V_{D_4}(S) = 2V_{0S} - V_{S_2} \quad \text{(Seuil)}$$

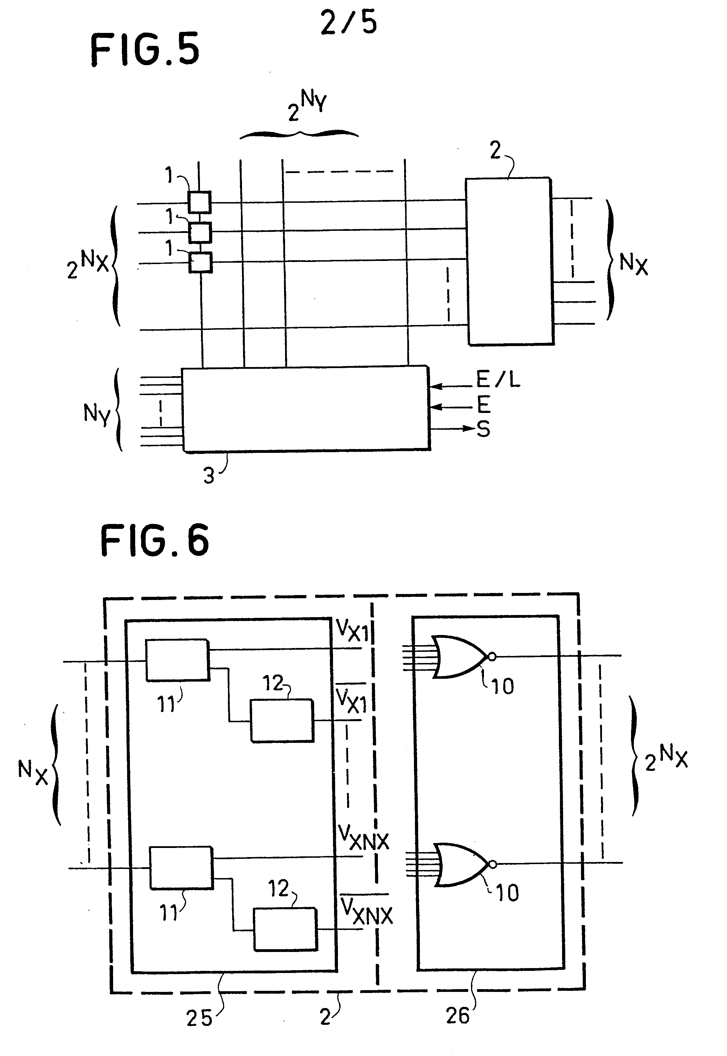

La figure 5 représente le schéma d'une mémoire à accès aléatoire utilisant les circuits bistables 1 selon l'invention.

Les éléments sont placés en lignes X et en colonnes Y.

Chaque ligne X est connectée au dispositif 2 d'adressage en X qui a $2^{NX}$ sorties, et NX entrées, NX étant bien entendu un nombre entier, $2^{NX}$ étant les nombres de lignes.

Les colonnes Y au nombre de $2^{NY}$ sont connectées au dispositif d'adressage 3 en Y qui a NY entrées et deux entrées supplémentaires, l'une, l'entrée E/L qui assigne les fonctions alternativement d'écriture ou de lecture de l'information de l'élément choisi, la deuxième E est une entrée qui, en écriture, permet l'entrée des données.

L'entrée E/L indique au dispositif la fonction qu'il doit assumer, lecture ou écriture.

Dans les deux cas une ligne et une colonne sont choisies. Donc seul l'élément à la croisée de la ligne choisie par le dispositif d'adressage 2 et de la colonne choisie par le dispositif d'adressage 3 est capable d'enregistrer l'information "1" ou "0" ou de la restituer suivant l'ordre reçu par l'entrée E/L.

Dans le cas où l'ordre d'enregistrement est donné, il enregistre l'état "0" ou "1" suivant la tension de l'entrée E. Dans le cas de la lecture, il délivre en S l'information qu'il contient, après sélection de la ligne et de la colonne voulues.

Les éléments de la mémoire statique à accès alléatoire décrits ici sont donc les suivants :

- Cellule de mémoire bistable décrite précédemment
- Porte d'adressage X (Lignes)
- Porte d'adressage Y (Colonnes)
- Demi circuit de commande d'entrée X (ou Y)
- Sélection d'Ecriture-Lecture
- Sélection d'Ecriture
- Amplificateur de lecture.

A la figure 6 est représenté le dispositif 2 d'adressage en X.

Chaque ligne X est commandée par une porte 10 qui permet de sélectionner le numéro de ligne en fonction des niveaux qui sont appliqués à son entrée.

On obtient ces niveaux à l'aide de deux demi circuits de commande identique 11 et 12 qui reproduisent les signaux logiques complémentaires pour les entrées des portes 10.

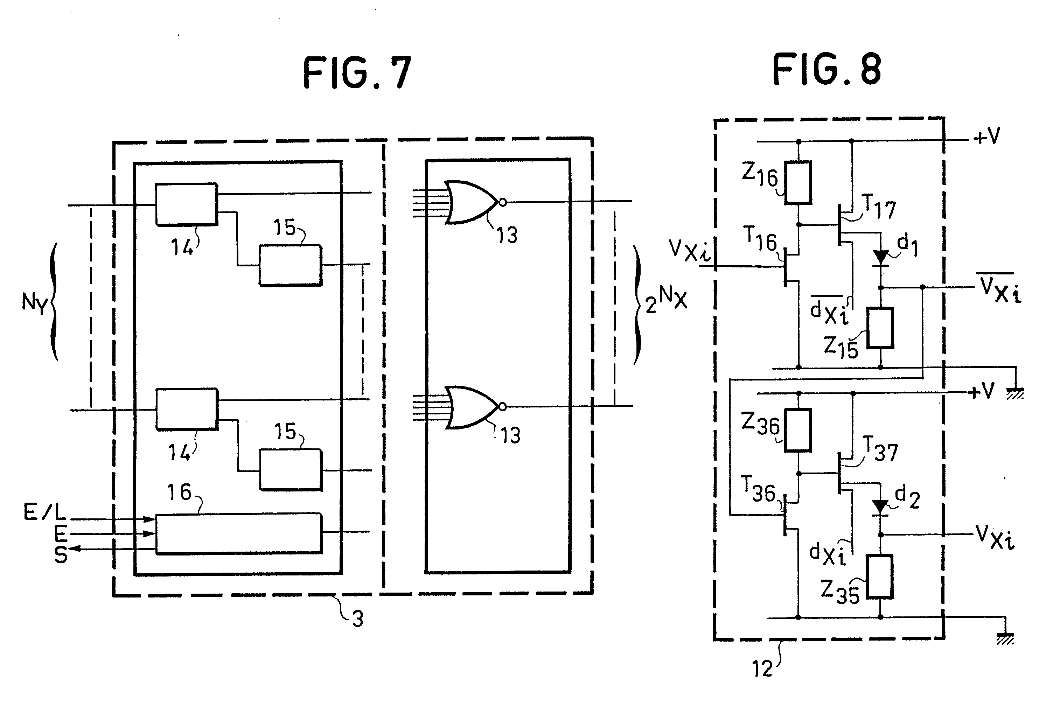

A la figure 7 est représenté le dispositif 3 d'adressage en Y.

Chaque colonne Y est commandée par une porte 13 qui permet de sélectionner le numéro de colonne en fonction des niveaux qui sont appliqués à son entrée.

On obtient ces niveaux à l'aide de deux demi circuits de commande 14, 15 identiques qui reproduisent les signaux logiques complémentaires pour les entrées des portes 13.

7

Le circuit 16 contient le circuit de sélection d'écriture-lecture dans lequel est entré le signal E/L et le signal E d'entrée de données dans le cas d'une écriture ; il contient aussi l'amplificateur de lecture qui délivre, en cas de lecture, le signal de sortie S.

Ainsi la figure 6 représente le schéma du dispositif 2 d'adressage en X. Il comprend 2NX circuits inverseurs logiques (11, 12) groupés dans le bloc 25, et $2^{NX}$ portes groupées dans l'ensemble 26.

On peut prendre comme exemple NX = 5 ; $2^{NX}$ étant par conséquent égal à 32.

Ces circuit de demi-commande sont montés comme indiqué figure 6. Il en résulte qu'à chaque entrée de l'ensemble 25, correspond deux sorties complémentaires $V_{Xi}$ et $\overline{V_{Xi}}$.

L'ensemble 26 comprend 32 portes OU-NON, dont les sorties respectives se mettent à l'état "1", quand les 5 entrées sont à l'état "0". Chacune de ces portes porte un numéro de 0 à 31.

Or, de chaque ligne $V_{Xi}$ ou $\overline{V_{Xi}}$ toujours l'une par définition est portée au niveau 1. De plus chaque nombre de 0 à 31, en numérotation binaire est un nombre de cinq chiffres, dont chacun est ou 1 ou 0. Le nombre 3 s'écrit par exemple 00011.

Pour exciter la porte 3, il suffira qu'elle soit reliée aux lignes $V_{X1}$, $V_{X2}$, $V_{X3}$ qui sont au niveau 0, et aux lignes $\overline{V_{X4}}$ et $\overline{V_{X5}}$ qui sont également au niveau 0.

Il est donc clair que pour obtenir l'adresse de la ligne $X_j$, il suffira d'appliquer aux entrées de l'ensemble les chiffres qui composent le nombre j, pour obtenir la ligne $X_j$, et par conséquent la sélection d'une ligne de la matrice.

Il faut alors sélectionner un élément de la ligne $X_j$, celui de la colonne $Y_K$ pour d'une part, écrire une information, ou d'autre part pour lire l'information qu'il contient. C'est le rôle du dispositif 3 d'adressage en Y représenté en figure 7.

Il joue le même rôle que le dispositif 2 d'adressage en X.

Mais il comprend en outre deux entrées, à savoir l'entrée E/L qui commande la fonction d'écriture ou lecture de l'information et l'entrée E qui dans le cas de l'écriture commande l'entrée d'un "0" ou d'un "1".

L'entrée E/L en position lecture permet d'obtenir l'information contenue dans l'élément adressé en sortie S.

A la figure 8 sont représentés les demi-circuits de commande qui sont les mêmes que l'on considère les lignes ou les colonnes. Ainsi chaque demi-commande (11, 12 ou 14, 15) reproduit les signaux logiques complémentaires qui permettront de sélectionner les numéros de ligne et colonne désirées. Chaque demi circuit de commande a un étage inverseur d'entrée constituée par un transistor à effet de champ $T_{16}$ et une charge $T_{14}$ reliée comme indiqué en figure 8. L'étage de sortie est constitué par un transistor à effet de champ $T_{17}$ à deux sources indépendantes, son drain étant relié à la tension d'alimentation +V. L'une des sources est reliée à la masse par une diode $d_1$ et une charge $Z_{15}$ en série et fournissant la sortie $V_{Xi}$ pour le deuxième demi-circuit de commande qui lui est identique. L'autre source est reliée à une ligne de $d_{xi}$ recevant le même signal que celui qui correspond à $V_{Xi}$. La deuxième demi-commande comporte les transistors à effet de champ $T_{36}$, $T_{37}$, et les charges $Z_{35}$ et $Z_{36}$. La deuxième source de $T_{37}$ constitue une sortie pour les diodes $d_{xi}$ recevant le signal correspondant à $V_{xi}$. Ces différents éléments sont reliés entre eux comme cela est représenté à la figure 8.

La figure 9 représente un dispositif de mémorisation réalisé à partir du circuit bistable illustré à la figure 4.

Ce circuit bistable 1 joue le rôle d'une cellule de mémoire à accès aléatoire. L'accès à la cellule se fait grâce aux transistors à effet de champ $T_4$ et $T_5$ commandés respectivement par une porte d'adressage X (ligne) 10 et une porte d'adressage Y (colonne) 13.

L'entrée des données E est isolée par le transistor à effet de champ $T_6$ commandé par un système de sélection Ecriture-Lecture.

Chaque ligne X est commandée par une porte X 10 constituée par un transistor à effet de champ $T_{10}$ et de charges $Z_6$ et $Z_7$ formant un inverseur simple à un étage. L'adressage de cette porte se fait par des diodes $d_{X1}$, $d_{X2} \dots d_{Xp}$ de base commune reliée à la grille du transistor $T_{10}$. Ces éléments sont reliés entre eux comme cela est représenté à la figure 9. L'accès à la colonne Y se fait grâce au transistor à effet de champ $T_5$ dont la grille est commandée par une porte Y 13 analogue à la porte X 10 précédente avec un transistor à effet de champ $T_{11}$, des charges $Z_8$ et $Z_9$ et

les diodes $d_{Y1}$, $d_{Y2}$ ... $d_{yq}$. Ces différents éléments sont reliés entre eux comme cela est représenté à la figure 9.

L'entrée des données E est isolée par le transistor à effet de champ $T_6$ dont la grille est commandée par la sélection Ecriture-Lecture constitué par un inverseur logique.

Les éléments de cette sélection Ecriture-Lecture sont :

- les transistors à effet de champ $T_{12}$, $T_{13}$, les résistances $Z_{10}$, $Z_{11}$ et la diode $d_{EL}$ ; ces éléments étant reliés entre eux comme cela est représenté à la figure 9.

Les signaux de E sont fournis par une sélection Ecriture qui est constituée par un inverseur logique identique à celui de la sélection Ecriture-Lecture, dont les éléments sont :

- les transistors à effet de champ $T_{14}$, $T_{15}$, les résistances $Z_{12}$, $Z_{13}$ et la diode $d_E$ ; ces éléments étant reliés entre eux comme cela est représenté à la figure 9.

L'amplificateur de lecture a deux étages : le premier étage est un circuit suiveur-décaleur constitué par le transistor à effet de champ $T_7$ la diode $d_{A1}$ et la résistance $Z_3$, le second est un inverseur logique de même type que celui de la sélection écriture dont les éléments sont les transistors $T_8$, $T_9$, les résistances $Z_4$, $Z_5$ et la diode $d_{A2}$. Ces différents éléments sont reliés entre eux comme cela est représenté à la figure 9.

Dans le cas d'écriture de l'état "0", on a les situations représentées dans le tableau II situé en fin de description.

Dans le premier cas (1) considéré, les transistors à effet de champ $T_6$, $T_5$ et $T_4$ sont passants. $V_{D4}$ est ramené aux niveaux bas : somme des chutes de tension de déchet des transistors $T_6$, $T_5$, $T_4$, avec un courant $i_{T_6}$ supérieur au courant de maintien de l'état "1" : $i_{T_3} - i_{T_1}$. La cellule bascule donc à l'état "0".

Dans le deuxième cas (2) considéré la colonne Y n'est pas adressée : les transistors $T_4$ et $T_6$ sont passants et le transistor $T_5$ est bloqué.

Dans le troisième cas (3) considéré la ligne X n'est pas adressée : les transistors $T_5$ et $T_6$ sont passants et le transistor $T_4$ est bloqué.

Dans ces deux derniers cas la cellule mémoire n'est pas adressée. Le courant $i_{T_4}$ est égal à une somme de courants inférieure au courant $i_{T_3} - $

$i_{T_1}$ : $i_{T_5}(o)$ et $i_{T_6}(o)$ étant les courants parasites dans les transistors $T_5$ et $T_6$ lorsqu'ils sont bloqués, la cellule reste donc dans un état stable.

Dans le quatrième cas, on effectue la lecture de la cellule mémoire avec les transistors $T_4$ et $T_5$ passants et le transistor $T_6$ bloqué. Les courants parasites sont trop faible pour changer l'état de la cellule.

Les conditions de basculement à "0" sont donc :

$$V_{D_4} < V_{D_4}(S)$$

($V_{D_4}$ étant la tension au point $D_4$, et $V_{D_4}(S)$ la tension de seuil au même point)

et $\quad i_{T_4} > i_{T_3} - i_{T_1}$

Dans le cas d'écriture de l'état "1" : on a les situations représentées dans le tableau III situé en fin de description.

On considère les mêmes quatre cas que ceux étudiés précédemment pour l'écriture de l'état "0".

Dans le premier cas (1) considéré les transistors à effet de champ $T_6$, $T_5$, $T_4$ sont passants, $D_4$ est forcé au niveau haut avec un courant $i_{T_6} + i_{G_4}$ supérieur au courant de maintien $i_{T_1}$ de l'état "0". La cellule bascule donc à l'état "1".

Dans le deuxième (2) et le troisième cas (3), les cellules mémoire non adressées sont restées stables car les courants parasites sont faibles devant $i_{T_1}$.

Dans le quatrième cas (4), la cellule en lecture reste stable pour la même raison.

Les conditions de forçage à "1" sont donc :

$$V_{D_4} > V_{D_4}(S)$$

($V_{D_4}$ étant la tension au point $D_4$ et $V_{D_4}(S)$ la tension de seuil au même point)

et $\quad i_{T_4} > i_{T_1}$

L'ordre de grandeur des niveaux est le suivant :

L'amplificateur de lecture détecte les niveaux "0" et "1" suivant que $V_{G_8}$ prend les tensions 0 ou $V_{0S}$.

Comme :

$$V_{G_8} = V_{D_4} - V_{S_7} - V_{0S}$$

D'où, les conditions :

$$V_{G_8}(B) = V_{D_4}(B) - V_{S_7} - V_{0S} \text{ (niveau bas)}$$

avec $V_{D_4}(B) = V_{0S} + V_{d_1}$ (tableau 1)

$$\Longrightarrow V_{G_8}(B) = V_{d_1} - V_{S_7} < 0$$

et $V_{G_8}(H) = V_{D_4}(H) - V_{S_7} - V_{0S}$ (niveau haut)

avec $V_{D_4}(H) = V - V_{S_3} - V_{0S}$ (tableau I)

$$\Longrightarrow V_{G_8}(H) = V - 2V_{0S} - V_{S_7} > V_{0S}$$

En prenant :

$$V_{S_3} + V_{S_7} \simeq V_{0S} \simeq 0.7 \text{ Volt}$$

et $+V > 4V_{0S}$

On obtient : $V \simeq 3$ Volts

$$V_{D_4}(B) \simeq 0.8 \text{ Volt (niveau bas)}$$

$$V_{D_4}(H) \simeq 2 \text{ Volts (niveau haut)}$$

$$V_{D_4}(S) \simeq 1.2 \text{ Volts (seuil)}$$

Ces niveaux montrent que la cellule est très stable avec une grande immunité aux bruits.

En résumé, les différents éléments de la mémoire statique décrits ici ont des caractéristiques représentées dans le tableau IV situé en fin de description.

Le niveau $V_{D_2}$ étant un niveau suiveur en fonction des niveaux de la charge jusqu'à 2 Volt ($V_{D_3}$ suit jusqu'à 3 Volt)

Le niveau F étant un niveau flottant.

La tension d'alimentation unique étant égale à 3 Volt.

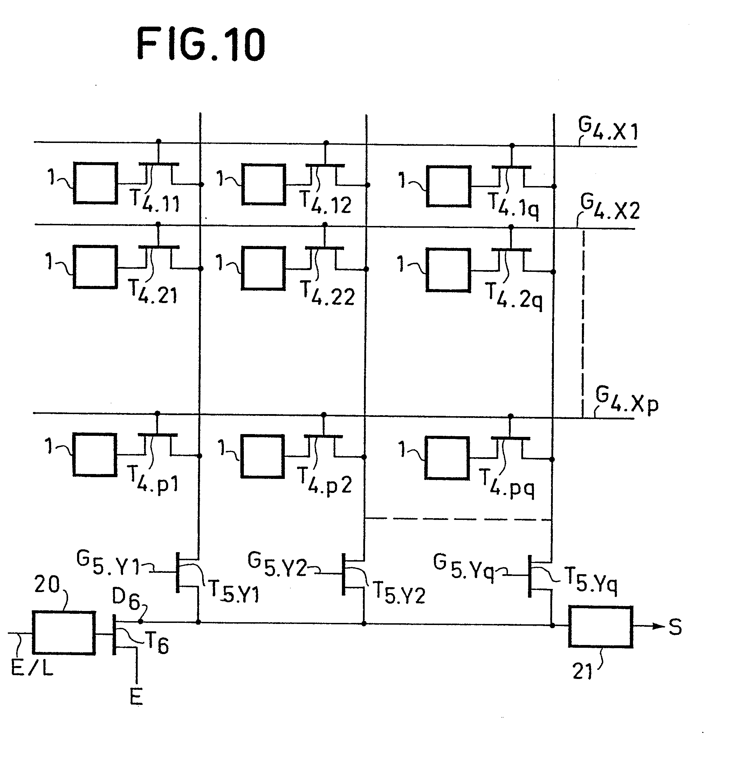

L'organisation de la mémoire est représentée en figure 10. Les cellules sont groupées en p lignes X et en q colonnes Y. Les lignes regroupent les grilles $G_4$, les colonnes regroupent les sources $S_4$ ; $G_4$ et $S_4$ étant les grilles et les sources des transistors $T_4$ de chaque cellule.

Chaque ligne est commandée par une porte d'adressage X. On accède à chaque colonne par un transistor à effet de champ $T_5$ dont la grille est commandée par une porte d'adressage Y. On pourrait tout aussi bien remplacer les transistors $T_4$ et $T_5$ correspondant à chaque cellule par des transistors bigrilles, chaque première grille étant reliée à la ligne d'adressage et chaque seconde grille à la colonne d'adressage considérée.

Les sources des transistors à effet de champ $T_5$ sont reliées d'une part au drain $D_6$ du transistor à effet de champ $T_6$ qui isole l'accès de l'entrée des données E et d'autre part à l'entrée de l'amplificateur de lecture 21.

La grille $G_6$ est commandée par le sélecteur d'écriture-lecture 20 décrit précédemment.

Les portes X et Y sont commandées par les circuits de demi-commande X et Y.

L'exemple d'une mémoire 256 bits organisée en 8 colonnes Y, 32 lignes X est donné dans le tableau V situé en fin de description.

On peut donc réaliser une mémoire de 256 bits dans un millimètre carré de surface. Quand à la consommation, on peut prendre 100 µW par élément en moyenne, ce qui fait au total de l'ordre de 30 mW.

Suivant ces ordres de grandeur, on peut envisager de réaliser des mémoires de 1024 bits dans les surfaces de 2 x 2 mm$^2$, avec une consommation de 120 mW seulement.

La vitesse d'accès de ces mémoires peut être inférieure à 1 nanoseconde.

TABLEAU I

| Etat logique | $V_{G_2}$ | $V_{G_3}$ | $V_{D_4}$ | $V_{GS_2}$ | $V_{GS_3}$ |
|---|---|---|---|---|---|
| "0" | $2V_{0S}$ | $V_{0S}+V_{d_1}+V_{d_2}$ | $V_{0S}+V_{d_1}$ | $V_{0S}-V_{d_1}$ | $V_{d_2}-V_{0S}$ |
| "1" | $2V_{0S}$ | $+V$ | $V-V_{S_3}-V_{0S}$ | $3V_{0S}+V_{S_3}-V$ | $V_{S_3}$ |

TABLEAU II

| $V_E$ | $V_{G_6}$ | $V_{G_5}$ | $V_{G_4}$ | $V_{D_4}$ | $i_{T_4}$ | Cas |
|---|---|---|---|---|---|---|
| 0 | $V_{0S}$ | $V_{0S}+V_{d_6}$ | $V_{0S}+V_{d_6}+V_{d_5}$ | $V_{d_6}+V_{d_5}+V_{d_4}$ | $i_{T_6}+i_{G_4}$ | 1 |
| 0 | $V_{0S}$ | $V_{d_{11}}$ | $V_{D_4}+V_{0S}$ | $V_{D_4}$ | $i_{T_5}(0)+i_{G_4}$ | 2 |
| 0 | $V_{0S}$ | $V_{0S}+V_{d_6}$ | $V_{d_{10}}$ | $V_{D_4}$ | 0 | 3 |
| 0 | 0 | $V_{D_4}+V_{0S}$ | $V_{D_4}+V_{0S}$ | $V_{D_4}$ | $i_{T_6}(0)+i_{G_4}$ | 4 |

14

TABLE III

| $V_E$ | $V_{G_6}$ | $V_{G_5}$ | $V_{G_4}$ | $V_{D_4}$ | $i_{T_4}$ | Cas |
|---|---|---|---|---|---|---|
| $V-V_{S_{15}}-V_{0S}$ | $V-V_{S_{13}}-V_{0S}$ | $V_{G_4}+V_{d_4}$ | $V_{D_4}+V_{0S}$ | $V_E-V_{d_6}-V_{d_5}-V_{d_4}$ | $I_{T_6}+i_{G_4}$ | 1 |
| $V-V_{S_{15}}-V_{0S}$ | $V-V_{S_{13}}-V_{0S}$ | $V_{d_{11}}$ | $V_{D_4}+V_{0S}$ | $V_{D_4}$ | $i_{G_4}$ | 2 |
| $V-V_{S_{15}}-V_{0S}$ | $V-V_{S_{13}}-V_{0S}$ | $V_E+V_{0S}$ | $V_{d_{10}}$ | $V_{D_4}$ | 0 | 3 |
| $V-V_{S_{15}}-V_{0S}$ | 0 | $V_{D_4}+V_{0S}$ | $V_{D_4}+V_{0S}$ | $V_{D_4}$ | $i_{G_4}$ | 4 |

15

## TABLEAU IV

| Elément | Nature | Sortie | | | Entrée | |
|---|---|---|---|---|---|---|
| | | Haut | Seuil | Bas | Haut | Bas |
| Cellule de mémoire | Bascule bistable | 2 | 1.2 | 0.8 | $V_{D_3}$ | 0.2 |
| Porte X | Inverseur simple | $V_{D_3}$ | | 0.2 | 1.4 | F |
| Porte Y | Inverseur simple | $V_{D_3}$ | | 0.2 | 1.4 | F |
| Circuit de demi-commande X, Y | Inverseur double + Double sortie | 0.7 / 1.4 | | 0 / F | 0.7 | 0 |
| Sélection Ecriture-Lecture | Inverseur double | $V_{D_2}$ | | 0 | 0.7 | 0 |
| Sélection Entrée | Inverseur double | 2 | | 0 | 0.7 | 0 |
| Amplificateur de lecture | Suiveur + inverseur double | $V_{D_2}$ | | 0 | 2 | 0.8 |

Commandes d'entrée de la mémoire

Sortie

TABLEAU V

| Elément | Nombre | Surface unitaire moyenne |
|---|---|---|
| Cellule | 256 | 50 x 50 $\mu m^2$ |
| Porte X | 32 | – |
| Circuit de demi-commande X | 5x2=10 | – |
| Porte Y | 8 | – |
| Circuit de demi commande Y | 3x2=6 | – |
| Sélecteur d'écriture/lecture | 1 | – |
| Sélecteur d'entrée des données | 1 | – |
| Amplificateur de lecture | 1 | – |
| Total | 315 | 0.75 $mm^2$ |

REVENDICATIONS

1. Circuit logique bistable utilisant des transistors à effet de champ à faible tension de seuil, connectés entre les deux bornes d'un générateur de tension d'alimentation, caractérisé en ce qu'il comporte deux transistors à effet de champ ($T_1$ et $T_2$) en série dont les grilles sont reliées entre elles et à la première borne du générateur de tension d'alimentation par une première charge ($Z_1$), la source du premier transistor à effet de champ ($T_1$) étant relié à la deuxième borne du générateur de tension d'alimentation, le drain du deuxième transistor à effet de champ ($T_2$) étant relié d'une part à la première borne du générateur de tension d'alimentation par une deuxième charge ($Z_2$) et d'autre part à la grille d'un troisième transistor à effet de champ ($T_3$) dont le drain est relié à la première borne du générateur de tension d'alimentation et la source au point commun constitué par le drain du premier transistor ($T_1$) et par la source du deuxième transistor ($T_2$) par l'intermédiaire d'une diode Schottky ($d_{c2}$) ; ce point commun constituant la borne de sortie dudit circuit bistable.

2. Circuit bistable selon la revendication 1, caractérisé en ce qu'il comprend en outre une diode Schottky ($d_{c1}$) polarisée dans le sens passant intercalée entre la source du premier transistor ($T_1$) et la deuxième borne du générateur de tension d'alimentation.

3. Dispositif de mémorisation selon la revendication 2, caractérisé en ce qu'il comporte des cellules mémoires constituées par des circuits selon la revendication 2.

4. Dispositif de mémorisation selon la revendication 3, caractérisé en ce que les cellules mémoires forment une matrice comportant des lignes et des colonnes d'adressage respectivement X et Y ; des circuits d'adressage en X et Y permettant de sélectionner la cellule désirée.

5. Dispositif de mémorisation selon la revendication 4, caractérisé en ce qu'un circuit d'adressage en X comporte un premier transistor à effet de champ ($T_4$) de sélection de la cellule mémoire, le drain de ce transistor étant relié au point de sortie de la cellule, et sa grille à une ligne d'adressage en X.

6. Dispositif de mémorisation selon la revendication 5, caractérisé en ce qu'un circuit d'adressage en Y comporte un second transistor à effet de champ ($T_5$) de sélection de la cellule mémoire, le drain de ce transistor étant relié à la source d'un premier transistor de sélection ($T_4$), sa grille étant reliée à une colonne d'adressage en Y.

7. Dispositif de mémorisation selon les revendications 5 et 6, caractérisé en ce que les premier et second transistor à effet de champ de sélection sont confondus en un seul transistor à effet de champ de sélection bigrille, l'une des grilles étant reliée à la ligne d'adressage en X et l'autre grille à la colonne d'adressage en Y.

8. Dispositif de mémorisation selon l'une quelconque des revendications 6 ou 7, caractérisé en ce qu'il comporte un dispositif de sélection de mode écriture-lecture, ce dispositif étant relié en sortie à la grille d'un transistor ($T_6$) dont le drain est relié soit à la source d'un deuxième transistor à effet de champ de sélection ou à la source d'un transistor à effet de champ bigrille.

9. Dispositif de mémorisation selon la revendication 8, caractérisé en ce que le dispositif de sélection écriture-lecture est un inverseur logique.

10. Dispositif de mémorisation selon l'une quelconque des revendications 6 ou 7, caractérisé en ce qu'il comporte un circuit de lecture ; ce circuit de lecture étant relié en entrée au drain d'un transistor ($T_6$) qui est relié aussi soit à la source d'un deuxième transistor à effet de champ de sélection, soit à la source d'un transistor à effet de champ bigrille.

11. Dispositif de mémorisation selon la revendication 10, caractérisé en ce que le circuit de lecture comporte deux étages, le premier étage étant un étage suiveur-décaleur, le deuxième étage étant un inverseur logique.

12. Dispositif de mémorisation selon l'une quelconque des revendications 6 ou 7, caractérisé en ce que chaque circuit d'adressage en X ou Y comporte une porte OU-NON à plusieurs entrées et une sortie reliée soit au drain d'un transistor de sélection en X ($T_4$) ou Y ($T_5$) soit au drain du transistor à effet de champ bigrille.

13. Dispositif de mémorisation selon la revendication 12, caractérisé en ce que les entrées des portes OU-NON sont commandées par des circuits de commande permettant de sélectionner le numéro de ligne et le numéro de colonne voulu.

14. Dispositif de mémorisation selon la revendication 13, caractérisé en ce que ces circuits de commande comportent deux circuits identiques ; chaque circuit comportant un étage inverseur d'entrée, l'étage de sortie étant constitué d'un transistor à effet de champ à deux sources indépendantes.

**FIG.1**

**FIG.2**

**FIG.3**

**FIG.4**

FIG.5

FIG.6

FIG. 8

FIG. 7

FIG.9

4/5

0073167

# FIG.10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y,A | --- <br> US-A-4 000 427  (HOFFMANN) <br><br> *Colonne 1, lignes 8-13; colonne 1, lignes 42-50; colonne 1, ligne 67 - colonne 2, ligne 14; colonne 2, lignes 54-59; colonne 2, ligne 68 - colonne 3, ligne 23; figures 1,2,4* | 1,3-5, 10 | G 11 C   11/40 <br> H 03 K    3/353 |
| Y,D | --- <br> EP-A-0 021 858  (THOMSON-CSF) <br> *Page 7, lignes 9-23; figure 12* | 1 | |
| A | --- <br> EP-A-0 033 033  (FUJITSU) <br> *Page 3, lignes 4-11; page 7, lignes 25-33; figures 3,6* | 1 | |
| A | --- <br> US-A-4 092 735  (McELROY) <br><br> ----- | 1,3-5 | DOMAINES TECHNIQUES RECHERCHES (Int. Cl. ³) <br><br> G 11 C   11/40 <br> H 03 K    3/353 <br> H 03 K    3/356 |

Le présent rapport de recherche a été établi pour toutes les revendications

| Lieu de la recherche | Date d'achèvement de la recherche | Examinateur |
|---|---|---|
| LA HAYE | 23-11-1982 | HARMS J.O |